# EUROPEAN PATENT APPLICATION

(11) **EP 4 672 878 A1**
(43) Date of publication of application: **31.12.2025**
(21) Application number: 25747817.2
(22) Date of filing: 24.01.2025
(51) Int. Cl.: H05K 5/02, H02M 1/00

(54) **INVERTER**

(30) Priority: 31.01.2024 US 202463627203 P
(71) Applicant: DELTA ELECTRONICS, INC., Taoyuan City 320023 (TW)
(72) Inventor: LEE, Ming-hsuan, Taoyuan City 320023, Taiwan (TW); TANG, Wei-chung, Taoyuan City 320023, Taiwan (TW)
(74) Representative: 2K Patentanwälte Blasberg Kewitz & Reichel
(86) International application number: PCT/CN2025/074657
(87) International publication number: WO 2025/162249

(57) **Abstract**

The disclosure is directed to an inverter having a housing tray, multiple first capacitors, multiple second capacitors and a first busbar assembly. The housing tray has a carrying surface defined with first caves and second caves. The first capacitors are respectively adhered in the first caves with thermal glue, and the second capacitors are respectively adhered in the second caves with thermal glue. The first busbar assembly is stacked on the carrying surface and electrically connected to the first capacitors and the second capacitors.

## Description

### Technical Field

This disclosure is directed to an inverter device, in particular to an inverter device which is easy to assemble.

### Description of Related Art

A vehicle inverter device generally has a main body and housing. The main body is accommodated in the housing and the housing is provided with connectors electrically connected to the main body for externally connecting to a power or loadings. In general, the main body has a circuit board and electronical components disposed on the circuit board. In a general assembling process, the circuit board is soldered with the electronical components and then fixed into the housing. The electrical components should be respectively arranged on predetermined positions on the circuit board by manual operation or automation in a process of soldering the electrical components onto the control board. The circuit board is then heated in a tin pot for soldering, and positioning errors of the electrical components may lead to malfunction of the inverter device.

Furthermore, gaps between the electronic components and the housing may lead to thermal resistances and therefore result in poor heat dissipation efficiency of the inverter device. Additional heat conduction channel should be arranged for dissipating the large amount of heat from the electronic components of the inverter device.

Accordingly, current assembly methods have expansive cost, low yield and inefficient heat dissipation.

In views of this, in order to solve the above disadvantage, the inventor studied related technology and provided a reasonable and effective solution in this disclosure.

### SUMMARY OF THE INVENTION

This disclosure is directed to an inverter device which is easy to assemble.

This disclosure is directed to inverter device, having a tray housing, a plurality of power inverting modules, a plurality of first capacitors and a first busbar assembly. The tray housing has a carrying surface, and at least one first cave defined on the carrying surface. The power inverting module are attached on the carrying surface. The first capacitors are respectively arranged in the first cave, the first cave is filled with thermal conductive glue to adhere the first capacitors, and each of the first capacitors has a plurality of capacitor electrodes. The first busbar assembly is stacked on the carrying surface and electrically connected to the first capacitors respectively. The capacitor electrodes of the first capacitors are respectively connected with the first busbar assembly at a plurality of junctions arranged in a line, and the power inverting modules are respectively connected with the first busbar assembly at a plurality of junctions arranged in a line.

In one embodiment of this disclosure, the inverter device further has a second busbar assembly, the second busbar assembly is stacked on the carrying surface and electrically connected to the power inverting modules.

In one embodiment of this disclosure, the second busbar assembly has a bracket and a plurality of second electrodes attached on the bracket, the second electrodes are coplanarly arranged on the bracket, the bracket is fastened on the carrying surface, and the second electrodes are respectively soldered with the power inverting modules.

In one embodiment of this disclosure, the power inverting modules are respectively connected with the second busbar assembly at a plurality of junctions arranged in a line the power inverting modules are respectively connected with the first busbar assembly at a plurality of junctions arranged in a line.

In one embodiment of this disclosure, the inverter device further has a control board, the first busbar assembly is stacked on the first capacitors and the power inverting modules, and the control board is stacked on the first busbar assembly and the power inverting modules.

In one embodiment of this disclosure, the first busbar assembly has a plurality of voltage terminals, the voltage terminals are respectively soldered with the control board.

In one embodiment of this disclosure, the first busbar assembly has a plurality of through windows arranged corresponding to the power inverting modules, the power inverting modules are respectively connected to the control board through the through windows correspondingly, and each of the power inverting modules has a plurality of legs, and the legs of the power inverting modules respectively penetrate the first busbar assembly to be soldered with the control board.

In one embodiment of this disclosure, each of the power inverting modules has at least a pair of output legs, the second electrodes are respectively connected to the output leg, and the second electrodes are respectively connected with the output legs at a plurality of junctions arranged in a line.

In one embodiment of this disclosure, the first capacitors are disposed in one line, the power inverting modules are disposed in another parallel line, the second electrodes are disposed in further another parallel line, and the second electrodes and the first capacitors opposite to each other at two sides of the power inverting modules.

In one embodiment of this disclosure, the bracket is disposed parallel to the power inverting modules.

In one embodiment of this disclosure, the bracket has a plurality of assembly caves, the second busbar assembly has a plurality of current sensors, the current sensors are respectively arranged in the assembly caves, and each of the assembly caves are filled with thermal conductive glue to adhere the current sensors.

In one embodiment of this disclosure, the second electrodes are respectively inserted in the current sensors.

In one embodiment of this disclosure, each of the current sensors is a magnetic sensor, the magnetic sensor has a Hall element and a shielding piece, the Hall element is disposed corresponding to the second electrode, and the second electrode and the Hall element are surrounded by the shielding piece.

In one embodiment of this disclosure, the inverter device further has two second capacitors, two second caves defined on the carrying surface of the tray housing, the second capacitors respectively disposed in two of the second caves, and the second caves are respectively filled with thermal conductive glue to adhere the second capacitors.

In one embodiment of this disclosure, a pair of output terminals are arranged between two of the second cave, and the pair of output terminals are respectively connected to the second capacitors and the first busbar assembly.

In one embodiment of this disclosure, in each of the second caves, a second longitudinal limiting protrusion, a second lateral limiting protrusion and a second normal limiting protrusion are provided. The second longitudinal limiting protrusions, the second lateral limiting protrusion and the second normal limiting protrusion respectively abut against the second capacitor to define a second gap between the second capacitor and an internal surface of the second cave, and the second gap is filled with thermal conductive glue. The second capacitor is positioned planarly by the second longitudinal limiting protrusion and the second lateral limiting protrusion and positioned normally by the second normal limiting protrusion, so that the second capacitor is limited at a position for electrically connecting to the output terminals.

In one embodiment of this disclosure, a plurality of heat exchanging chambers are arranged on the carrying surface, and the power inverting modules are respectively disposed corresponding to the heat exchanging chambers, the first caves are arranged adjacent to the heat exchanging chambers for a heat transferring from the first caves to the heat exchanging chamber through the tray housing.

In one embodiment of this disclosure, the heat exchanging chambers are disposed in one line, and the first caves are disposed in another parallel line.

In one embodiment of this disclosure, the inverter device further has a capacitor electrode bracket, the capacitor electrode bracket is fastened in the tray housing, and the capacitor electrodes of the first capacitors are respectively fixed on the capacitor electrode bracket.

In one embodiment of this disclosure, in each of the first capacitors, the capacitor electrodes are attached on a top surface of the first capacitor.

In one embodiment of this disclosure, a first longitudinal limiting protrusion, a first lateral limiting protrusion and a first normal limiting protrusion are arranged on an internal surface of the first cave, the first longitudinal limiting protrusion, the first lateral limiting protrusion and the first normal limiting protrusion respectively abutting against the first capacitor to define a first gap between the first capacitor and an internal surface of the first cave, and the first gap is filled with thermal conductive glue.

In an assembling process of the inverter device according to this disclosure, the first caves and the second caves on the tray housing may be respectively filled with specific amount of thermal conductive glue in advance. Then the first capacitors and the second capacitors are respectively arranged into the first caves and the second caves, and the power inverting modules and the second busbar assembly fastened onto the tray housing. The aforementioned structure facilitates positioning of separated components, the first busbar assembly and the control circuit board are sequentially stacked on the carrying surface to complete the positioning for further soldering.

Furthermore, the electronic components (capacitors) with higher heat generation are adhered to the tray housing with thermal conductive glue, so that the thermal resistance between the electronic components and the tray housing may be reduced, thereby improving heat dissipation efficiency of the inverter device.

### BRIEF DESCRIPTION OF THE DRAWINGS

FIG. 1 is a perspective view showing an inverter device according to an embodiment of this disclosure;
FIG. 2 is another perspective view showing the inverter device according to the embodiment of this disclosure;
FIG. 3A is an exploded view of the inverter device according to the embodiment of this disclosure;
FIG. 3B is another exploded view of the inverter device according to the embodiment of this disclosure;
FIG. 4A is a perspective view showing interior structures of the inverter device according to the embodiment of this disclosure;
FIG. 4B is still another exploded view of the inverter device according to the embodiment of this disclosure;
Fig. 4C is a circuit diagram of the inverter device according to the embodiment of this disclosure;
FIG. 5 is still another exploded view of the inverter device according to the embodiment of this disclosure;
FIG. 6 is a perspective view showing a tray housing of the inverter device according to the embodiment of this disclosure;
FIG. 7 is a perspective view showing first capacitors assembled in the inverter device according to the embodiment of this disclosure;
FIG. 8 is a perspective view showing second capacitors assembled in the inverter device according to the embodiment of this disclosure;
FIG. 9 is a perspective view showing power inverting modules assembled in the inverter device according to the embodiment of this disclosure;
FIG. 10 is a perspective view showing the second busbar assembly assembled in the inverter device according to the embodiment of this disclosure;
FIG. 11 is a perspective view showing components carried on the tray housing of the inverter device according to the embodiment of this disclosure;
FIG. 12 is a cross-sectional view along a cutting plane line 12-12 as shown in FIG. 11 for illustrating components carried on the tray housing of the inverter device according to the embodiment of this disclosure;
FIG. 13 is a cross-sectional view of the inverter device according to the embodiment of this disclosure along a cutting plane line 13-13 as shown in FIG. 4A;
FIG. 14 is an enlarged view of a portion in FIG 13.

### Mark numbers

100: tray housing
100a: cover
101: carrying surface
110: first cave
111: first longitudinal limiting protrusion
112: first lateral limiting protrusion
113: first normal limiting protrusion
114: thermal conductive glue
120:second cave ;
121: second longitudinal limiting protrusion
122: second lateral limiting protrusion
123: second normal limiting protrusion
124: thermal conductive glue
130: heat exchanging chamber
140: serial connection channel
210: first capacitor
213: capacitor electrode
220: second capacitor
230: power inverting module
231: leg
232a, 232b: module electrode
233: output leg
310: first bus bar assembly
311: through window
312a, 312b: electrode soldering point
313: capacitor soldering point
314: terminal soldering point
315: output terminal
316: voltage terminal
320: second bus bar assembly
321: bracket
321a: assembly cave
322: second electrode
323: current sensor
323a: shielding piece
330: capacitor electrode bracket
400: control board

### DETAILED DESCRIPTION

The technical contents of this disclosure will become apparent with the detailed description of embodiments accompanied with the illustration of related drawings as follows. It is intended that the embodiments and drawings disclosed herein are to be considered illustrative rather than restrictive.

It should be understood that the orientations or positional relationships in this disclosure which are indicated by the terms such as "front side", "rear side", "left side", "right side", "front end", "rear end", "end", "vertical", "horizontal", "top" and "bottom" are based on the orientations or positional relationships as shown in the drawings. These are only used for describing this disclosure and simplifying the description rather than indicating or implying that the device or element have a specific orientation or be constructed and operated in a specific orientation, and it should not be considered as limitations of the scopes of this disclosure.

The terms used herein without additional definition such as "substantially" and "approximately" are used to describe and illustrate small changes. When used in an event or situation, the term may include the precise moment at which the event or situation occurs, and a close approximation to moment the event or situation occurs. For example, when combined with a numerical value, the term may include a range of variation less than or equal to ±10% of the numerical value, such as less than or equal to ±5%, less than or equal to ±4%, less than or equal to ±3%, less than or equal to ±2%, less than or equal to ±1%, less than or equal to ±0.5%, less than or equal to ±0.1%, or less than or equal to ±0.05%.

Detailed descriptions and technical contents of this disclosure is described in the flowing paragraph with reference to the drawings. However, the drawings are attached only for illustration and are not intended to limit this disclosure.

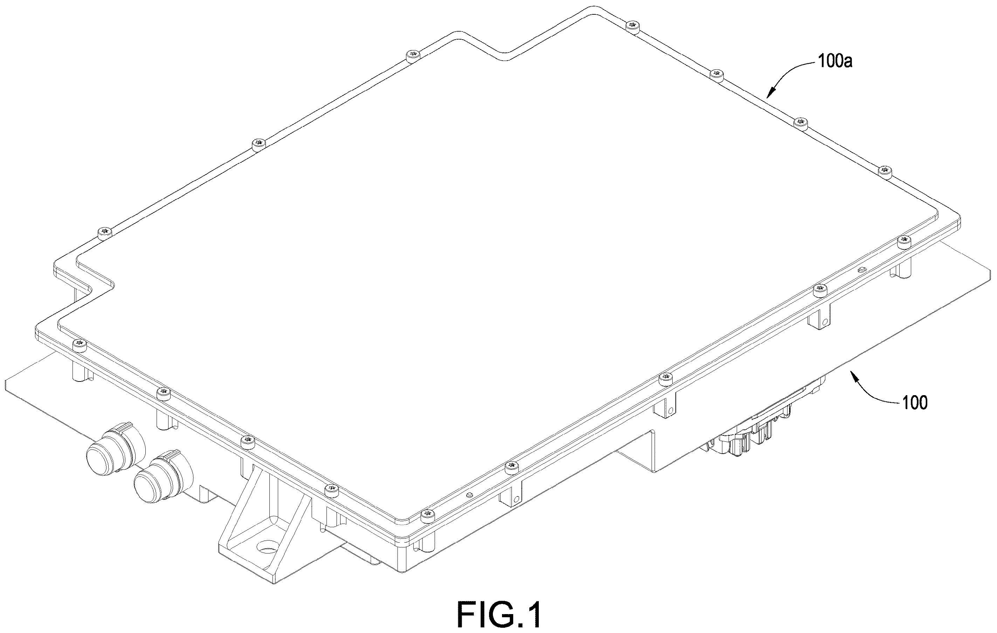

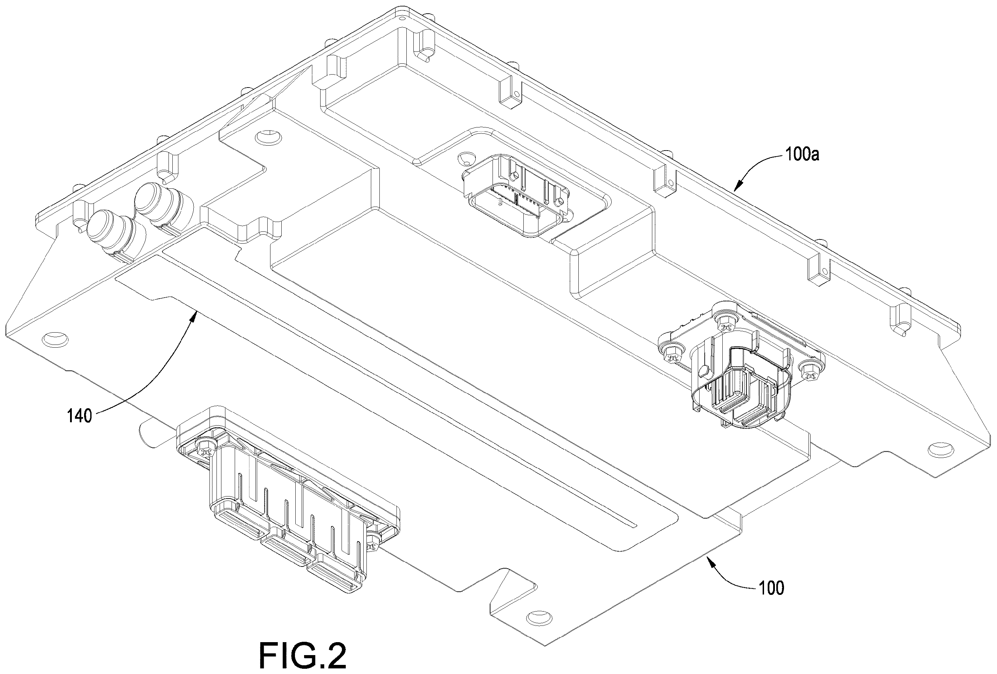

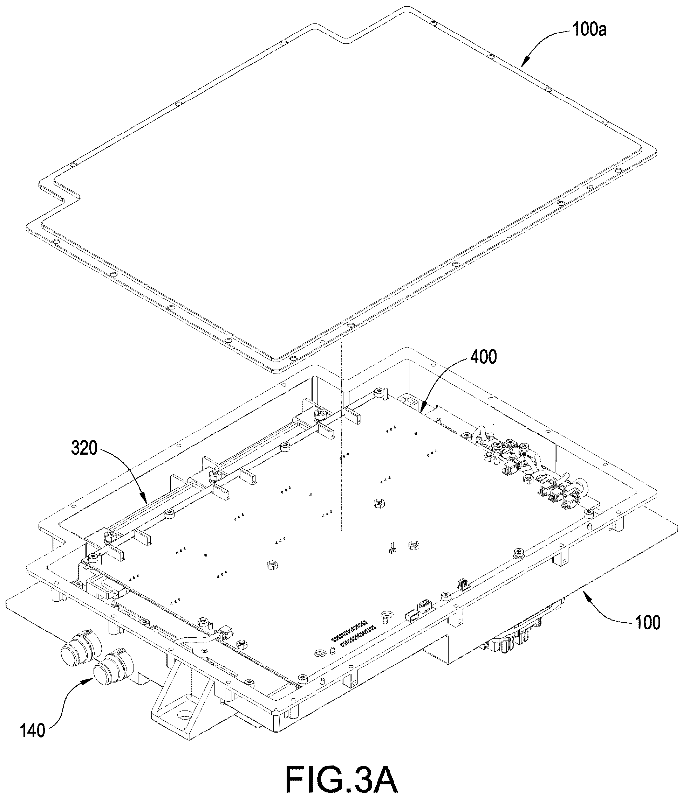

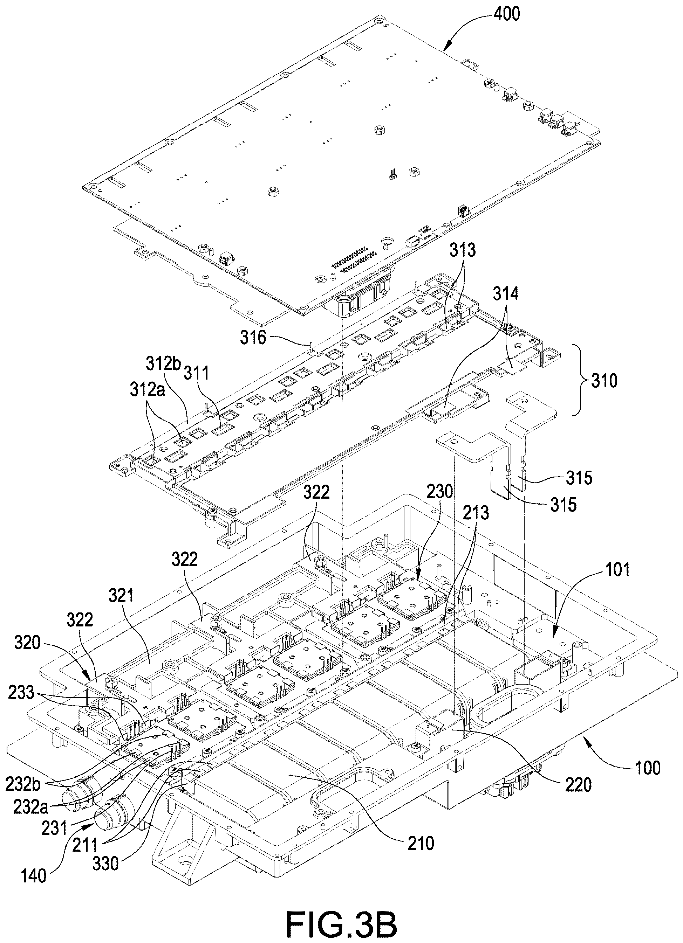

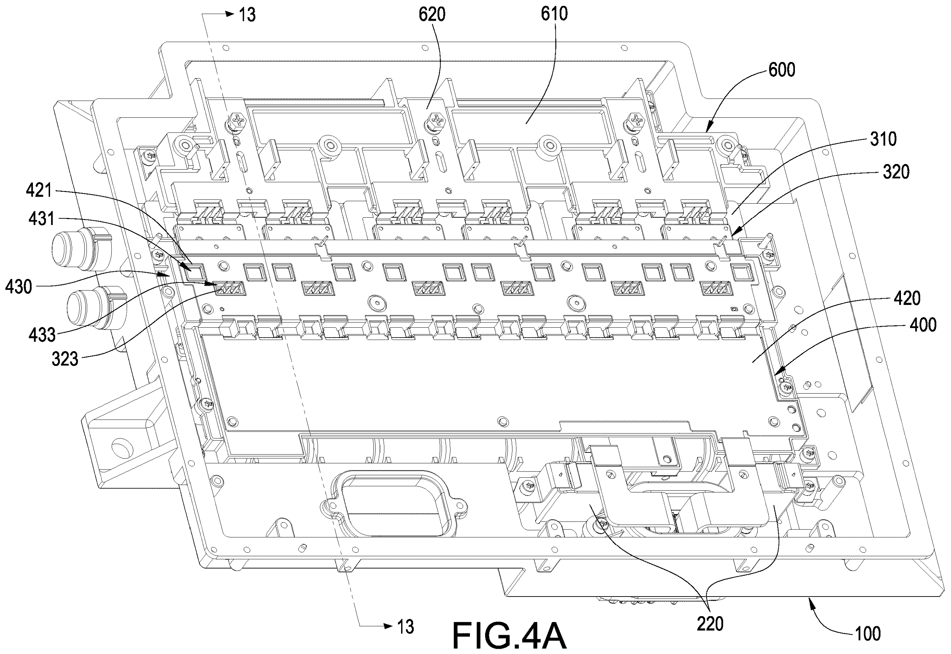

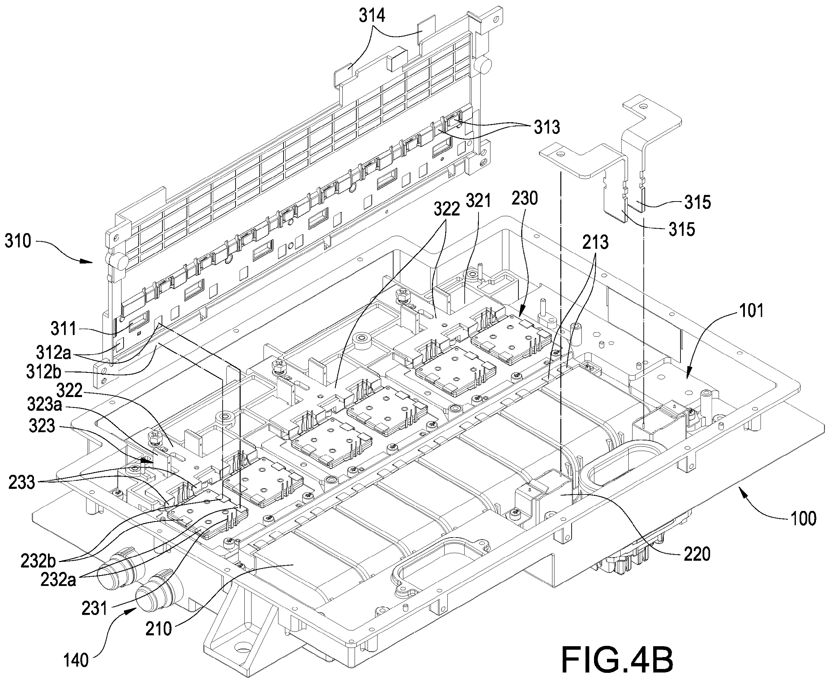

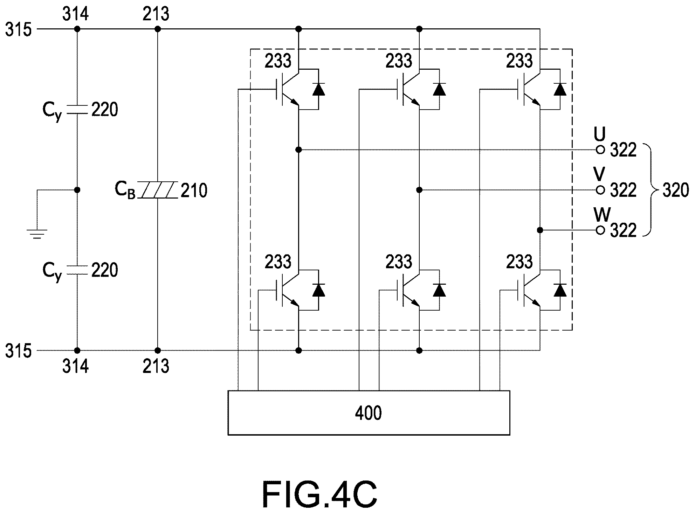

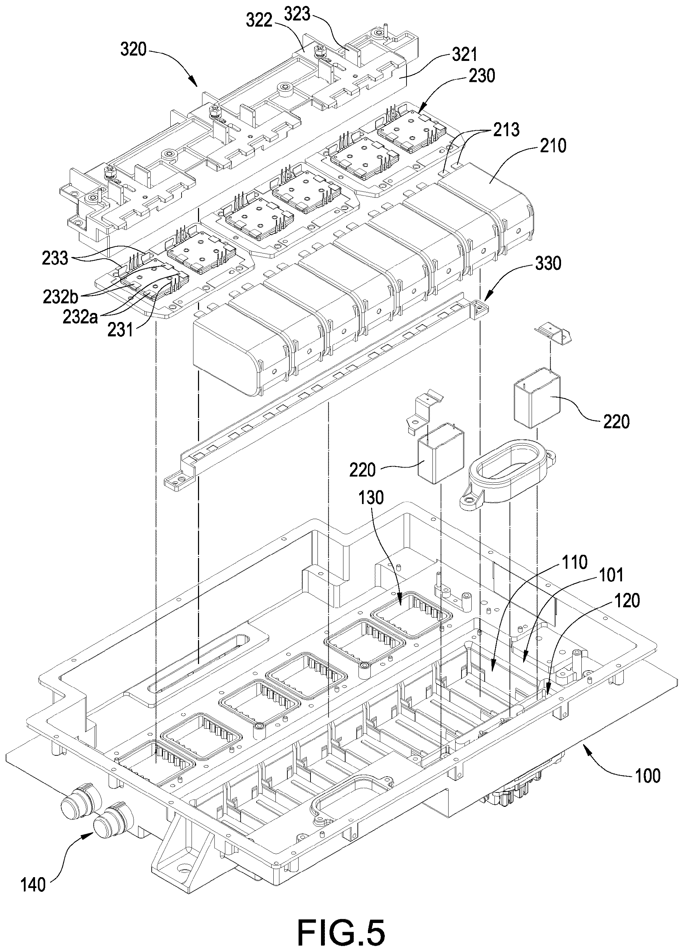

FIG. 1 is a perspective view showing an inverter device according to an embodiment of this disclosure. FIG. 2 is another perspective view showing the inverter device according to the embodiment of this disclosure. FIG. 3A is an exploded view of the inverter device according to the embodiment of this disclosure. FIG. 3B is another exploded view of the inverter device according to the embodiment of this disclosure. FIG. 4A is a perspective view showing interior structures of the inverter device according to the embodiment of this disclosure. FIG. 4B is still another exploded view of the inverter device according to the embodiment of this disclosure. Fig. 4C is a circuit diagram of the inverter device according to the embodiment of this disclosure. FIG. 5 is still another exploded view of the inverter device according to the embodiment of this disclosure.

According to an inverter device of one embodiment of this disclosure as shown in FIGS. 1 to 5, the inverter device at least has a tray housing 100, a plurality of first capacitors 210, a plurality of second capacitors 220, a plurality of power inverting modules 230, a first busbar assembly 310, a second busbar assembly 320 and a control board 400. According to this embodiment, the inverter device further has a cover 100a for closing the tray housing 100. Electrical connections between the components are illustrated in circuits as shown in FIG. 4C. The first capacitors 210 are buck capacitors used for restricting currents in the power inverting modules 230 respectively, and the second capacitors 220 are used for filtering DC power supplying to the first busbar assembly 310.

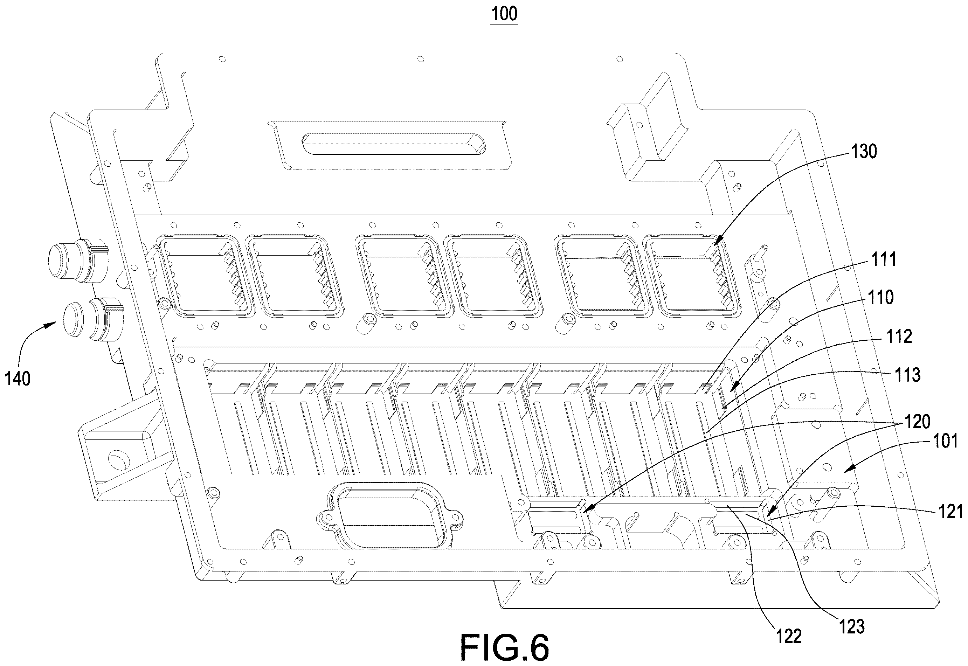

FIG. 6 is a perspective view showing a tray housing of the inverter device according to the embodiment of this disclosure. According to this embodiment as shown in FIG. 6, the tray housing 100 is made of metal, a carrying surface 101 is defined in the tray housing 100, and at least a plurality of first caves 110 and a plurality of second caves 120 are defined in the tray housing 100. The carrying surface 101 is directed to a portion on an internal surface of the tray housing 100 which may be used for carrying the components such as portions excluding a peripheral wall of the tray housing 100, rather than a designated flat or curved plane. Specifically, the first caves 110 and the second caves 120 are dented from the carrying surface 101. According to this embodiment, a plurality of heat exchanging chambers 130 are defined in the tray housing 100, and the heat exchanging chambers 130 are dented from the carrying surface 101. The first caves 110 are disposed adjacent to the heat exchanging chambers 130, the heat exchanging chambers 130 are arranged in one line and serially connected via a serial connection channel 140, and the first caves 110 are arranged in another line parallel to the line of the heat exchanging chambers 130 or the serial connection channel 140.

The first caves 110 as shown in this embodiment have identical structures. In each of the first caves 110, a first longitudinal limiting protrusion 111, a first lateral limiting protrusion 112 and a first normal limiting protrusion 113 are arranged on the internal surface of the first cave 110, the first normal limiting protrusion 113 is protruded from a bottom surface in the first cave 110 toward an opening of the first cave 110, the first longitudinal limiting protrusion 111 and the first lateral limiting protrusion 112 are respectively protruded from lateral surfaces in the first cave 110 along two directions perpendicular to each other. The second caves 120 as shown in this embodiment have identical structures. In each of the second caves 120, a second longitudinal limiting protrusion 121, a second lateral limiting protrusion 122 and a second normal limiting protrusion 123 are arranged in the second cave 120, the second normal limiting protrusion 123 is protruded from a bottom surface in the second cave 120 toward an opening of the second cave 120, the second longitudinal limiting protrusion 121 and the second lateral limiting protrusion 122 are respectively protruded from lateral surfaces in the second cave 120 along directions perpendicular to each other.

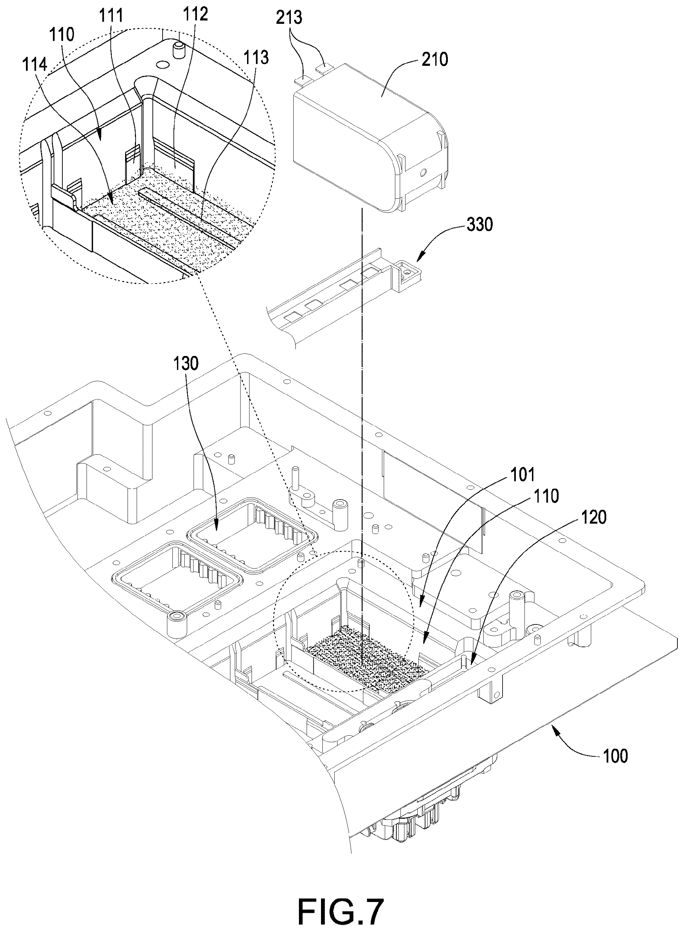

FIG. 7 is a perspective view showing the first capacitors assembled in the inverter device according to the embodiment of this disclosure. According to FIG. 7, the inverter device according to this embodiment is provided with a plurality of first capacitors 210 which are identical, and a plurality of first caves 110 are arranged in the tray housing 100 correspondingly, the first capacitors 210 are respectively arranged in the first caves 110. However, the first capacitors 210 may be arranged together in one first cave 110. According to this embodiment, the first capacitors 210 are respectively arranged in the first caves 110 with identical arrangement, and an example of only one of the first caves 110 and the first capacitor 210 therein is illustrated in following paragraphs. This first cave 110 is filled with thermal conductive glue 114, and the first capacitor 210 is fixed to the tray housing 100 by adhering with the thermal conductive glue 114. Heat from the first capacitor 210 in operation may be transferred from the first cave 110 to the heat exchanging chamber 130 through the tray housing 100. The first capacitors 210 are electrically connected with the first busbar assembly 310 at a plurality of junctions arranged in a line parallel to legs 231 of the power inverting module 230. The first capacitor 210 is positioned along one lateral direction (relative to the bottom surface in the first cave 110) by the first longitudinal limiting protrusion 111 in the first cave 110, the first capacitor 210 is positioned along another lateral direction by the first lateral limiting protrusion 112 in the first cave 110, and the first capacitor 210 is positioned along a normal direction by the first normal limiting protrusion 113 in the first cave 110. Accordingly, electrical junctions on the first capacitor 210 and the electrical junctions on the first busbar assembly 310 are positioned relative to each other for soldering.

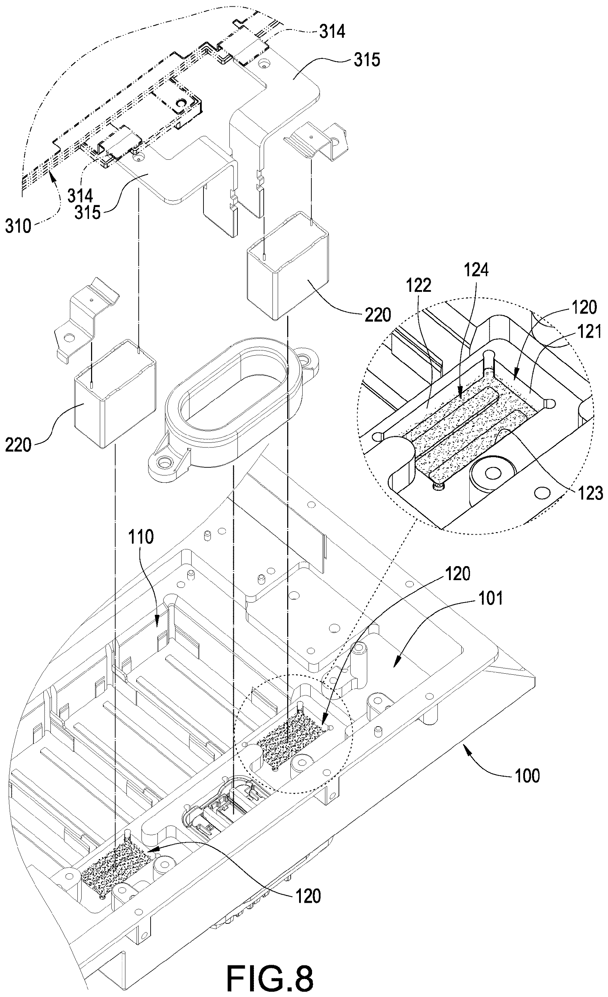

FIG. 8 is a perspective view showing second capacitors assembled in the inverter device according to the embodiment of this disclosure. According to FIG. 8, the second capacitors 220 are respectively arranged in the second caves 120, and an example of only one of the second cave 120 and the second capacitor 220 therein is illustrated in following paragraphs. This second cave 120 is filled with thermal conductive glue 124, and the second capacitor 220 is fixed to the tray housing 100 by adhering with the thermal conductive glue 124.

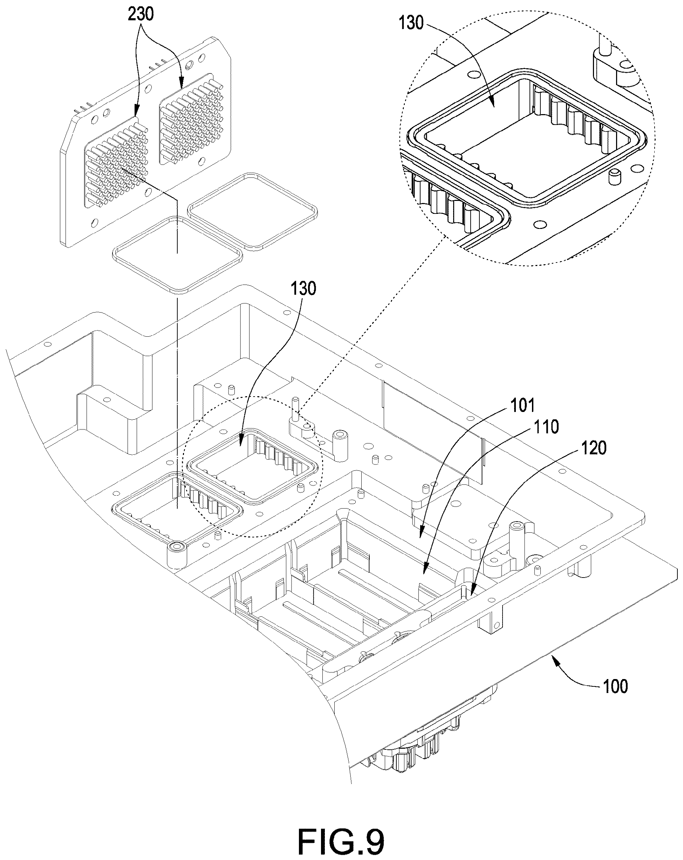

FIG. 9 is a perspective view showing power inverting modules assembled in the inverter device according to the embodiment of this disclosure. According to FIG. 9, the power inverting modules 230 are attached on the carrying surface 101. Specifically, the power inverting modules 230 are fastened on the carrying surface 101, and the power inverting modules 230 are respectively disposed corresponding to the heat exchanging chambers 130. According to this embodiment, each of the power inverting modules 230 has a portion accommodated in the heat exchanging chamber 130 correspondingly.

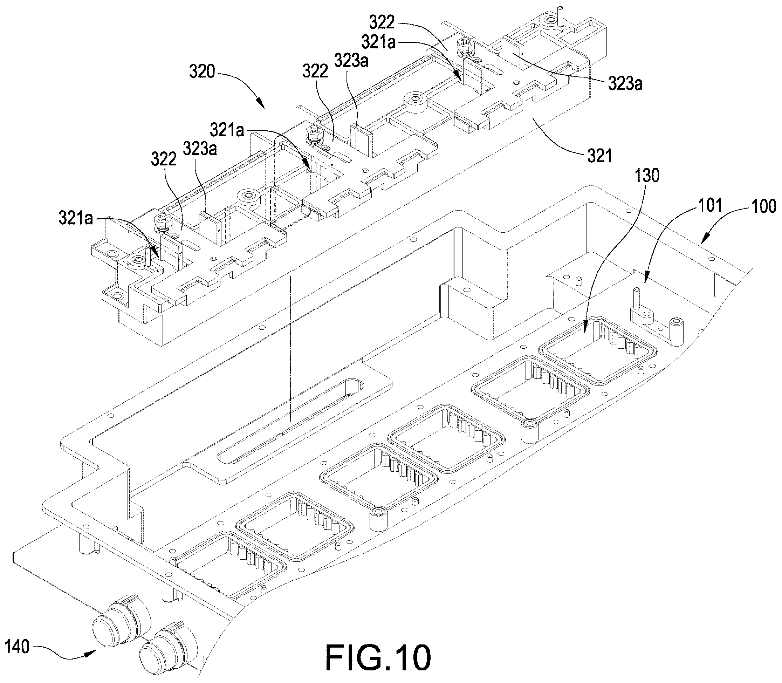

FIG. 10 is a perspective view showing the second busbar assembly 320 assembled in the inverter device according to the embodiment of this disclosure. According to FIG. 10, the second busbar assemblies 320 are stacked on the carrying surface 101 and electrically connected with the power inverting modules 230. The second busbar assembly 320 is fastened on the carrying surface 101. The second busbar assembly 320 has a bracket 321 and a plurality of second electrodes 322 attached in the bracket 321, the second electrodes 322 are arranged on the bracket 321 substantially in a coplanar arrangement, the bracket 321 is fastened on the carrying surface 101 and the second electrodes 322 are respectively soldered with the power inverting module 230. The bracket 321 is provided with a plurality of assembly caves 321a, the second busbar assembly 320 has a plurality of current sensors 323, the current sensors 323 are respectively arranged in the assembly caves 321a, and the assembly caves 321a are respectively filled with glue to adhere the current sensors 323. The second electrodes 322 respectively penetrate the current sensors 323 correspondingly, and the current sensors 323 of this disembodiment are current sensors. Each of the current sensors according to this embodiment generally has a Hall element (not shown in figures) and a shielding piece 323a, the Hall elements are arranged in the circuit on the control board 400 at locations corresponding to the second electrodes 322, and the shielding pieces 323a are fixed in the assembly caves 321a by adhering. Specifically, the shielding piece 323a is of U a shape for correspondingly surrounding the second electrode 322 and the Hall element, thereby concentrating the magnetic field generated by the second electrode 322 to the Hall element. The shielding piece 323a is made of ferromagnetic which is used for concentrating a portion of the magnetic field to amplify the change of the magnetic field, and the of the Hall element are therefore more sensitive and accurate.

According to this embodiment, the second busbar assembly 320 has a plurality of second electrodes 322 for multi-phase output (the output is generally three-phase but not limited to three-phase in this disclosure), the second electrodes 322 are arranged on the same plane.

According to this embodiment, the second busbar assembly 320 is provided with three second electrodes 322, DC current may be transferred into three-phase AC current by the power inverting modules 230 and output through the second electrode 322.

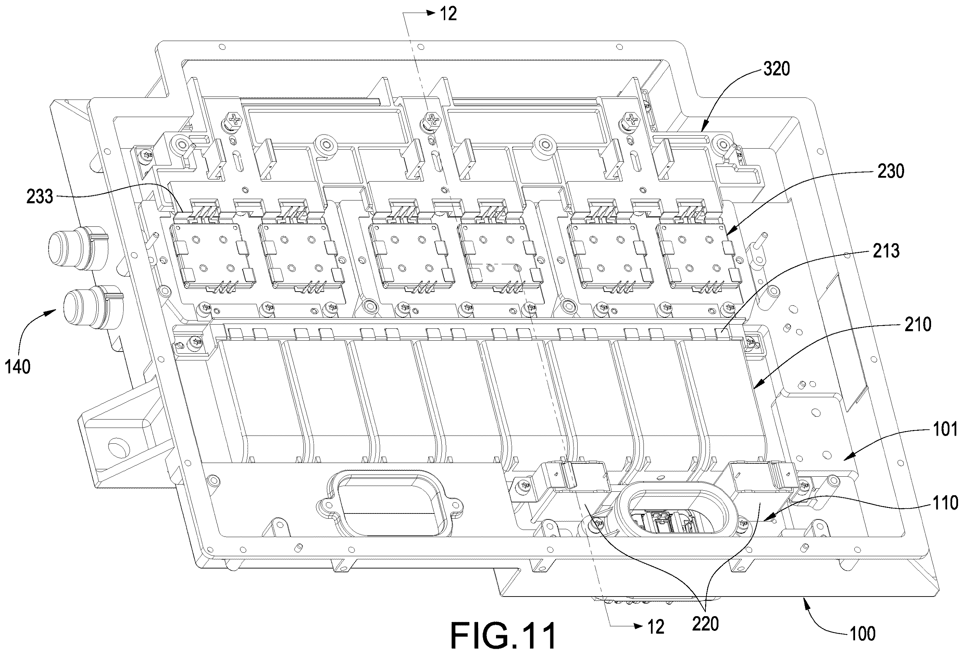

According to FIG. 11, the first cave 110 and the second cave 120 of the tray housing 100 may be filled with specific amount of thermal conductive glue (114, 124) in advance, and then the first capacitor 210 and the second capacitor 220 are respectively arranged into the first cave 110 and the first cave 110, and the power inverting module 230 and the second busbar assembly 320 are further fastened to the tray housing 100. The structure mentioned above is easy to be assembled.

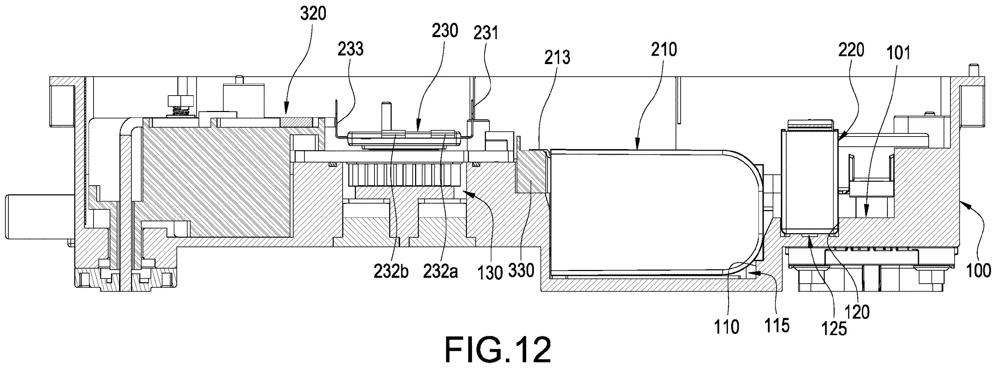

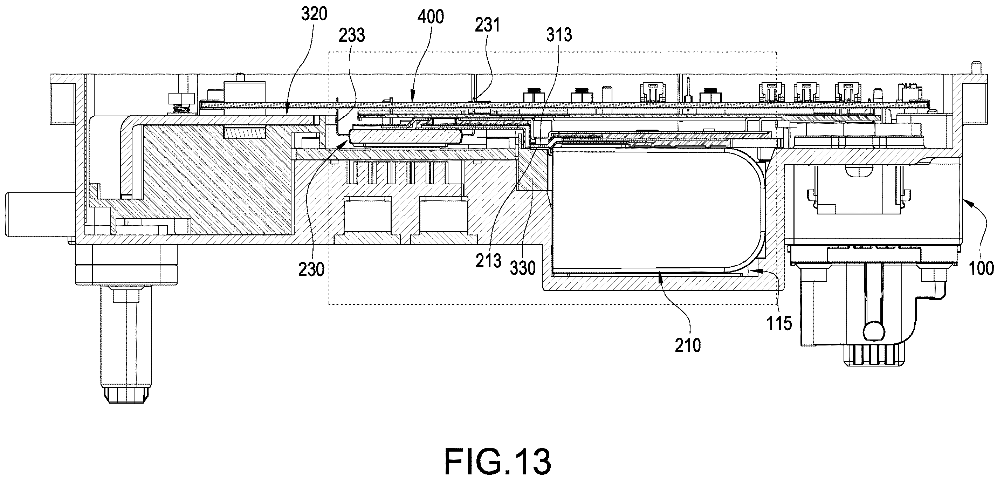

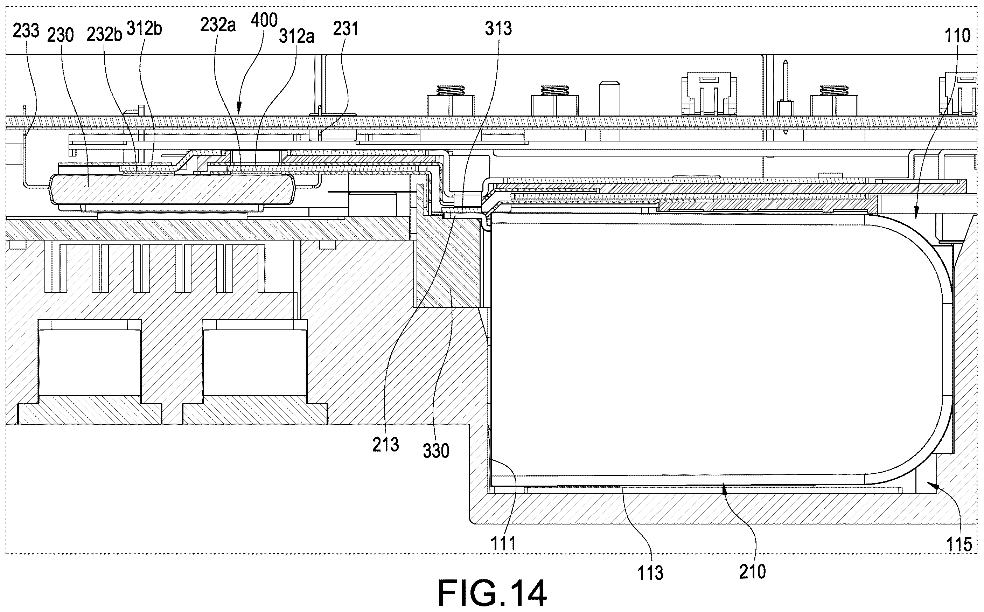

FIG. 12 is a cross-sectional view along a cutting plane line 12-12 as shown in FIG. 11 for illustrating components carried on the tray housing of the inverter device according to the embodiment of this disclosure. FIG. 13 is a cross-sectional view of the inverter device according to the embodiment of this disclosure along a cutting plane line 13-13 as shown in FIG. 4A. FIG. 14 is an enlarged view of a portion in FIG 13. According to FIGS. 7 and FIGS. 12 to 14, first capacitor 210 has a bottom accommodated in the first cave 110 so that the first capacitor 210 protrudes from the first cave 110. The first longitudinal limiting protrusion 111, the first lateral limiting protrusion 112 and the first normal limiting protrusion 113 in the first cave 110 respectively abut against the bottom of the first capacitor 210 accommodated in the first cave 110 to define a first gap 115 between the first capacitor 210 and the internal surface of the first cave 110. Specifically, the first capacitor 210 is put into the first cave 110, and the thermal conductive glue 114 prearranged as shown in FIG. 7 is squeezed and finally filled into the first gap 115 as shown in FIG. 12.

According to FIGS. 8 and 12, the second capacitor 220 has a bottom accommodated in the second cave 120 so that the second capacitor 220 protrudes from the second cave 120. The second longitudinal limiting protrusion 121, the second lateral limiting protrusion 122 and the second normal limiting protrusion 123 in the second cave 120 respectively abut against the bottom of the second capacitor 220 accommodated in the second cave 120 to define a second gap 125 between the second capacitor 220 and the internal surface of the second cave 120. Specifically, the second capacitor 220 is put into the second cave 120, and the thermal conductive glue 124 prearranged as shown in FIG. 8 is squeezed and finally filled into the second gap 125 as shown in FIG. 12.

According to FIGS. 3B to 4B, the first busbar assembly 310 is stacked on the carrying surface 101 and electrically connected to the first capacitors 210 and the second capacitors 220. The first busbar assembly 310 is stacked on the first capacitors 210 and the second capacitors 220. The first capacitors 210 and the second capacitors 220 are respectively soldered with the first busbar assembly 310.

According to FIGS. 4A to 5 again and also according to FIGS. 11 to 14, the first capacitors 210, the power inverting modules 230 and the second busbar assembly 320 are substantially arranged together in a plane the first capacitor 210 and the power inverting modules 230 are arranged side by side, and the second busbar assembly 320 is disposed at a side of the power inverting module 230 opposite to the first capacitor 210. Specifically, the first capacitors 210 are arranged in one line and the power inverting modules 230 are arranged in another line, the power inverting modules 230 and the second busbar assembly 320 are respectively arranged at two sides of the first capacitors 210, the first busbar assembly 310 is stacked on the plane. Each of the power inverting modules 230 has a plurality of legs 231, at least one pair of module electrodes (232a, 232b) and at least one pair of output legs 233. The legs 231 are extended upward and soldered with the control board 400, the module electrodes (232a, 232b) are arranged on a top of the power inverting module 230 and soldered with the first busbar assembly 310, one module electrode 232a of the pair of module electrodes (232a, 232b) is connected to an anode, and another module electrode 232b is connected to a cathode. The module electrodes 232a corresponding to the anodes are arranged in one line, and the module electrodes 232b corresponding to the anodes are arranged in another line parallel to the line mentioned above. The output legs 233 are arranged at one side of the power inverting modules 230, adjacent to the second busbar assembly 320 and soldered to the second electrodes 322 correspondingly. Moreover, the second electrodes 322 are respectively connected with the output legs 233 at a plurality of junctions arranged in further another line parallel to the lines mentioned above.

According to FIGS. 3B to 5, a capacitor electrode bracket 330 is fastened in the tray housing 100, the capacitor electrodes 213 of the first capacitor 210 are extended to the capacitor electrode bracket 330 and carried in the capacitor electrode bracket 330, and each of the first capacitors 210 has a pair of capacitor electrodes 213. According to this embodiment, each of the first capacitors 210 has the capacitor electrodes 213 protruded from a side on a top thereof and extended toward the power inverting module 230, and the pairs of capacitor electrodes 213 of the first capacitors 210 are respectively fixed on the capacitor electrode bracket 330, so that the capacitor electrodes 213 are positioned for soldering the capacitor electrode 213 with the first busbar assembly 310. However, the scopes of this disclosure should not be limited to the embodiment. In one example, each of the first capacitors 210 has the capacitor electrodes 213 attached on a top surface thereof and may be therefore soldered with the first busbar assembly 310 without the capacitor electrode bracket 330.

According to FIG. 4B, specifically, the capacitor electrodes 213 of the first capacitors 210 are electrically connected with the first busbar assembly 310 at a plurality of junctions arranged in one line, and the second electrodes 322 are correspondingly electrically connected with the output legs 233 of the power inverting modules 230 at a plurality of junctions arranged in another parallel line. Moreover, the serial connection channel 140 is disposed between two of the lines.

The control board 400 is stacked on the carrying surface 101 and electrically connected to the power inverting modules 230 and the first busbar assembly 310, and the control board 400 may control DC current input to the power inverting modules 230 through the first busbar assembly 310.

According to FIGS. 3B to 4B, in this embodiment, the control board 400 is stacked on the first busbar assembly 310 and the power inverting modules 230, and the power inverting module 230 and the first busbar assembly 310 are respectively soldered to the control board 400. The first busbar assembly 310 has a plurality of voltage terminals 316, the voltage terminals 316 are soldered with the control board 400 so that the control board 400 may detect voltage in the first busbar assembly 310 and control the power inverting module 230 accordingly. The first busbar assembly 310 has a plurality of through windows 311 disposed corresponding to the power inverting modules 230. Each of the power inverting modules 230 has a plurality of legs 231, the legs 231 are soldered with the control board 400, and the control board 400 may control the power inverting modules 230 through the legs 231. Moreover, some legs 231 of each of the power inverting modules 230 are inserted through the through window 311 correspondingly for soldering with the control board 400.

According to FIGS. 3B to 4B, the first busbar assembly 310 has a plurality electrode soldering points (312a, 312b) corresponding to the anode and the cathode for respectively soldered to the module electrodes (232a, 232b) of the power inverting module 230, each of the electrode soldering points (312a, 312b) has two surfaces exposed on two surfaces of the first busbar assembly 310, the electrode soldering point (312a/312b) is contacted to the module electrode (232a/232b) correspondingly via one of the surfaces thereon and soldered by laser through another one of the surfaces. The first busbar assembly 310 has a plurality of capacitor soldering points 313 respectively soldered with the capacitor electrodes 213 of the first capacitors 210. Each of the capacitor soldering points 313 has two surfaces respectively exposed on the two surfaces of the first busbar assembly 310, capacitor soldering point 313 is contacted to the capacitor electrode 213 correspondingly via one of the surfaces thereon and soldered by laser through another one of the surfaces. The first busbar assembly 310 has a pair of terminal soldering points 314 extended from an edge thereof, a pair of output terminals 315 are arranged on the terminal soldering points 314. The output terminals 315 may be fixed on the tray housing 100 in advance and then respectively soldered with the terminal soldering points 314, and the pair of output terminals 315 are further respectively connected with the second capacitors 220. The second capacitors 220 are symmetrically arranged at two sides of the pair of output terminals 315. Specifically, the first busbar assembly 310 assembled as shown in FIG. 3B, the electrode soldering point (312a, 312b), the capacitor soldering point 313, and the terminal soldering points 314 are exposed for processing laser soldering processes at the same time. According to FIG. 4B, the output terminals 315 are arranged between two of the second capacitors 220.

According to FIG. 8, the second capacitor 220 is positioned planarly by the second longitudinal limiting protrusion 121 and the second lateral limiting protrusion 122 and positioned normally by the second normal limiting protrusion 123, so that the second capacitor 220 is limited at a position for electrically connecting to the output terminals 315.

According to FIGS. 4B and 4C, currents are input into the power inverting modules 230 along paths from the output terminals 315 through the second capacitors and the first capacitors, and then output through the second electrodes 322. The inverter device according to the disclosure has the current transmission paths provided with the same components along which are arranged in symmetrical structure with electrical and thermal connections in parallel, thereby uniforming the electrical and heat dissipation performance of each circuit through the power inverting module 230. Characteristic differences between the circuits and mutual influence may be avoid to optimize overall conversion efficiency.

In an assembling process of the inverter device according to this disclosure as shown in FIG. 11, the first caves 110 and the second caves 120 on the tray housing 100 may be respectively filled with specific amount of thermal conductive glue (114,124) in advance. Then the first capacitors 210 and the second capacitors 220 are respectively arranged into the first caves 110 and the second caves 120, and the power inverting modules 230 and the second busbar assembly 320 are fastened onto the tray housing 100. The aforementioned structure facilitates positioning of separated components. According to FIG. 3B, the first busbar assembly 310 and the control circuit board 400 are sequentially stacked on the carrying surface 101 to complete the positioning for further soldering. Finally, the tray housing 100 is closed with the cover 100a covering on the carrying surface 101, and the inverter device is completely assembled.

Furthermore, the electronic components (capacitors) with higher heat generation are adhered to the tray housing 100 with thermal conductive glue (114, 124), so that the thermal resistance between the electronic components and the tray housing 100 may be reduced, thereby improving heat dissipation efficiency of the inverter device.

While this disclosure has been described by means of specific embodiments, numerous modifications and variations may be made thereto by those skilled in the art without departing from the scope and spirit of this disclosure set forth in the claims.

## Claims

1. An inverter device, comprising:
a tray housing, comprising a carrying surface, and at least one first cave defined on the carrying surface;
a plurality of power inverting modules, attached on the carrying surface;
a plurality of first capacitors, respectively arranged in the first cave, the first cave being filled with thermal conductive glue to adhere the first capacitors, and each of the first capacitors comprising a plurality of capacitor electrodes; and
a first busbar assembly, stacked on the carrying surface and electrically connected to the first capacitors respectively,
wherein the capacitor electrodes of the first capacitors are respectively connected with the first busbar assembly at a plurality of junctions arranged in a line, and the power inverting modules are respectively connected with the first busbar assembly at a plurality of junctions arranged in a line.

2. The inverter device according to claim 1, further comprising a second busbar assembly, the second busbar assembly is stacked on the carrying surface and electrically connected to the power inverting modules.

3. The inverter device according to claim 2, wherein the second busbar assembly comprising a bracket and a plurality of second electrodes attached on the bracket, the second electrodes are coplanarly arranged on the bracket, the bracket is fastened on the carrying surface, and the second electrodes are respectively soldered with the power inverting modules.

4. The inverter device according to claim 2, wherein the power inverting modules are respectively connected with the second busbar assembly at a plurality of junctions arranged in a line the power inverting modules are respectively connected with the first busbar assembly at a plurality of junctions arranged in a line.

5. The inverter device according to claim 2, further comprising a control board, the first busbar assembly is stacked on the first capacitors and the power inverting modules, and the control board is stacked on the first busbar assembly and the power inverting modules.

6. The inverter device according to claim 5, wherein the first busbar assembly comprises a plurality of voltage terminals, the voltage terminals are respectively soldered with the control board.

7. The inverter device according to claim 6, wherein the first busbar assembly comprises a plurality of through windows arranged corresponding to the power inverting modules, the power inverting modules are respectively connected to the control board through the through windows correspondingly, and each of the power inverting modules comprises a plurality of legs, and the legs of the power inverting modules respectively penetrate the first busbar assembly to be soldered with the control board.

8. The inverter device according to claim 3, wherein each of the power inverting modules comprises at least a pair of output legs, the second electrodes are respectively connected to the output legs, and the second electrodes are respectively connected with the output legs at a plurality of junctions arranged in a line.

9. The inverter device according to claim 8, the first capacitors are disposed in one line, the power inverting modules are disposed in another parallel line, the second electrodes are disposed in further another parallel line, and the second electrodes and the first capacitors opposite to each other at two sides of the power inverting modules.

10. The inverter device according to claim 9, wherein the bracket is disposed parallel to the power inverting modules.

11. The inverter device according to claim 9, wherein the bracket comprises a plurality of assembly caves, the second busbar assembly comprises a plurality of current sensors, the current sensors are respectively arranged in the assembly caves, and each of the assembly caves are filled with thermal conductive glue to adhere the current sensors.

12. The inverter device according to claim 11, wherein the second electrodes are respectively inserted in the current sensors.

13. The inverter device according to claim 11, wherein each of the current sensors is a magnetic sensor, the magnetic sensor comprises a Hall element and a shielding piece, the Hall element is disposed corresponding to the second electrode, and the second electrode and the Hall element are surrounded by the shielding piece.

14. The inverter device according to claim 1, further comprising two second capacitors, two second caves defined on the carrying surface of the tray housing, the second capacitors respectively disposed in two of the second caves, and the second caves are respectively filled with thermal conductive glue to adhere the second capacitors.

15. The inverter device according to claim 14, wherein a pair of output terminals are arranged between two of the second cave, and the pair of output terminals are respectively connected to the second capacitors and the first busbar assembly;
wherein the second capacitors are symmetrically arranged at two sides of the pair of output terminals.

16. The inverter device according to claim 15, wherein, in each of the second caves, a second longitudinal limiting protrusion, a second lateral limiting protrusion and a second normal limiting protrusion are provided therein;
wherein the second longitudinal limiting protrusion, the second lateral limiting protrusion and the second normal limiting protrusion respectively abut against the second capacitor to define a second gap between the second capacitor and an internal surface of the second cave, and the second gap is filled with thermal conductive glue;
wherein the second capacitor is positioned planarly by the second longitudinal limiting protrusion and the second lateral limiting protrusion and positioned normally by the second normal limiting protrusion, so that the second capacitor is limited at a position for electrically connecting to the output terminal.

17. The inverter device according to claim 1, wherein a plurality of heat exchanging chambers are arranged on the carrying surface, and the power inverting modules are respectively disposed corresponding to the heat exchanging chambers, the first caves are arranged adjacent to the heat exchanging chambers for a heat transferring from the first caves to the heat exchanging through the tray housing.

18. The inverter device according to claim 17, wherein the heat exchanging chambers are disposed in one line, and the first caves are disposed in another parallel line.

19. The inverter device according to claim 1, further comprising a capacitor electrode bracket, the capacitor electrode bracket is fastened in the tray housing, and the capacitor electrodes of the first capacitors are respectively fixed on the capacitor electrode bracket.

20. The inverter device according to claim 1, wherein in each of the first capacitors, the capacitor electrodes are attached on a top surface of the first capacitor.

21. The inverter device according to claim 1, wherein a first longitudinal limiting protrusion, a first lateral limiting protrusion and a first normal limiting protrusion are arranged on an internal surface of the first cave (110);
wherein the first longitudinal limiting protrusion, the first lateral limiting protrusion and the first normal limiting protrusion respectively abutting against the first capacitor to define a first gap between the first capacitor and an internal surface of the first cave, and the first gap is filled with thermal conductive glue; wherein the first capacitor is positioned planarly by the first longitudinal limiting protrusion and the first lateral limiting protrusion and positioned normally by the first normal limiting protrusion, so that the capacitor electrode of the first capacitor first capacitor is limited at a position for electrically connecting to the first busbar assembly.
